# EUROPEAN PATENT APPLICATION

(11) **EP 2 642 305 A2**
(43) Date of publication of application: **25.09.2013**
(21) Application number: 13152361.5
(22) Date of filing: 23.01.2013
(51) Int. Cl.: G01R 31/02

(54) **System and method to detect a short to ground of an external sensor return line**

(30) Priority: 21.03.2012 US 201213425499
(71) Applicant: Delphi Technologies, Inc., Troy, MI 48007 (US)
(72) Inventor: Ripley, Eugene, Russiaville, IN Indiana 46979 (US); Mowery, Kenneth, Noblesville, IN Indiana 46060 (US)
(74) Representative: Neill, Andrew Peter

(57) **Abstract**

A controller (14), a system (10), and a method (400) to detect a short to ground condition of a return line (16) of an external sensor (12) that outputs a sensor signal (26) relative to the return line (16). A ground switch (28) that electrically connects the return line (16) to a ground potential (30) when the ground switch (28) is in the closed state is momentarily opened, and one or more sensor signals are checked to determine if the sensor signals change as expected when the ground switch (28) is opened. If a value change (34) of a sensor signal (26) is less than a threshold value when the ground switch (28) is switched from the closed state to the open state, then a short to ground condition of the return line (16) is indicated.

## Description

### TECHNICAL FIELD OF INVENTION

This disclosure generally relates to detecting a short to ground condition of a return line, and more particularly relates to using a ground switch to electrically float the return line and detecting that a short to ground condition exists based on a change of an external sensor signal when the ground switch is momentarily opened.

### BACKGROUND OF INVENTION

Regulations for emission control systems of vehicle engines require that the systems be able to detect wire harness fault conditions such as a short to battery or a short to ground. These regulations are sometimes referred to as On-Board-Diagnostics regulations, or OBD-II when referring to a second revision of those regulations. A short to ground may occur, for example, if the insulation protecting a wire in the wire harness is damaged. If a wire makes electrical contact with the vehicle chassis, an electrical short of the wire to the chassis (ground) may occur. Ways to detect shorts to ground of signal wires expected to have a voltage potential other than ground potential are known. However, detecting a short to ground of a return line, that is a line or wire that is supposed to be at or near ground potential, can be difficult since there is little or no change of the expected potential caused by the short to ground.

### SUMMARY OF THE INVENTION

In accordance with one embodiment, a controller configured to detect a short to ground condition of a return line electrically coupled to an external sensor is provided. The external sensor is configured to output a sensor signal relative to the return line. The controller includes a ground switch and a processor. The ground switch is operable to a closed state and an open state. The ground switch is configured to electrically connect the return line to a ground potential when the ground switch is in the closed state. The processor is configured to receive the sensor signal, and operate the ground switch to the closed state and the open state. The processor detects a short to ground condition of the return line if a value change of a sensor signal is less than a threshold value when the ground switch is switched from the closed state to the open state.

In another embodiment, a system configured to detect a short to ground condition of a return line of the system is provided. The system includes an external sensor, a ground switch, and a processor. The external sensor is electrically coupled to the return line and is configured to output a sensor signal relative to the return line. The ground switch is operable to a closed state and an open state. The ground switch is configured to electrically connect the return line to a ground potential when the ground switch is in the closed state. The processor is configured to receive the sensor signal, and operate the ground switch to the closed state and the open state. The processor detects a short to ground condition of the return line if a value change of a sensor signal is less than a threshold value when the ground switch is switched from the closed state to the open state.

In yet another embodiment, a method to detect a short to ground condition of a return line electrically coupling an external sensor to a controller is provided. The method includes the step of providing a ground switch coupled to the return line. The ground switch is operable to a closed state and an open state, and is configured to connect the return line to a ground potential when the ground switch is in the closed state. The method also includes the step of determining a signal first value of a sensor signal from the external sensor while the ground switch is in the closed state. The method also includes the step of determining a signal second value of the sensor signal from the external sensor while the ground switch is in the open state. The method also includes the step of indicating that a short to ground condition of the return line exists if a value change indicative of a difference between the signal first value and the signal second value is less than a threshold value.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is a diagram of a system to detect a short to ground condition of a return line in accordance with a first embodiment;
Fig. 2 is diagram of a system to detect a short to ground condition of a return line in accordance with a second embodiment;
Fig. 3 is a graph of a signal present in the systems of Figs. 1 or 2; and
Fig. 4 is flowchart of a method performed by the systems of Figs. 1 or 2 in accordance with one embodiment.

### DETAILED DESCRIPTION

Described herein is a means to detect a short to ground condition of a return line electrically coupled to an external sensor. Typically, the external sensor outputs a sensor signal having a voltage potential or sensor signal value that is measured relative to the return line. If the return line is shorted to ground by, for example, making unexpected electrical contact with a vehicle chassis that differs by some ground shift value, then the sensor signal may be influenced in such a way that the information conveyed by the sensor signal becomes inaccurate or includes undesirable noise.

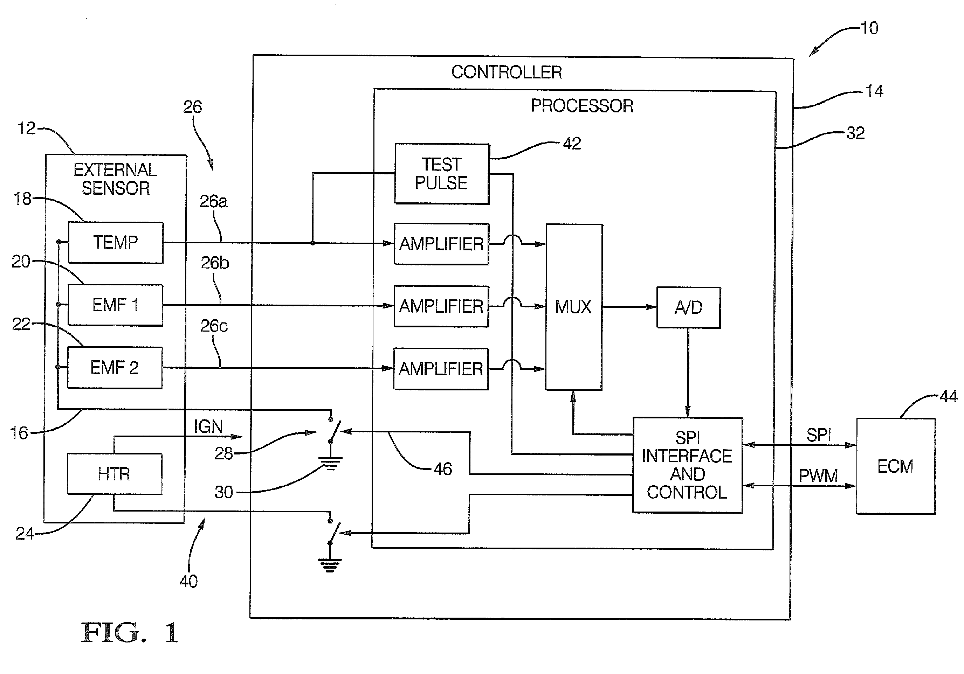

Fig. 1 illustrates a non-limiting example of a system 10 that includes an external sensor 12 electrically coupled to a controller 14 by a return line 16. In this non-limiting example, the external sensor 12 is an ammonia (NH3) sensor sold by Delphi Corporation having administrative offices in Troy, Michigan. However, it is recognized that the detection of a short to ground condition of the return line 16 may be used for other sensor types such as an exhaust oxygen sensor. The NH3 sensor includes a temperature sensor cell 18, a first gas sensing cell (EMF1) 20, a second gas sensing cell (EMF2), and a heater element 24. The temperature sensor cell 18, the first gas sensing cell (EMF1) 20, and the second gas sensing cell (EMF2) are all electrically connected to the return line 16 in order to provide a reference voltage to the cells. The external sensor 12 also outputs a sensor signal 26 to the controller 14, in this non-limiting example a temperature signal 26a, a first cell signal 26b, and a second cell signal 26c.

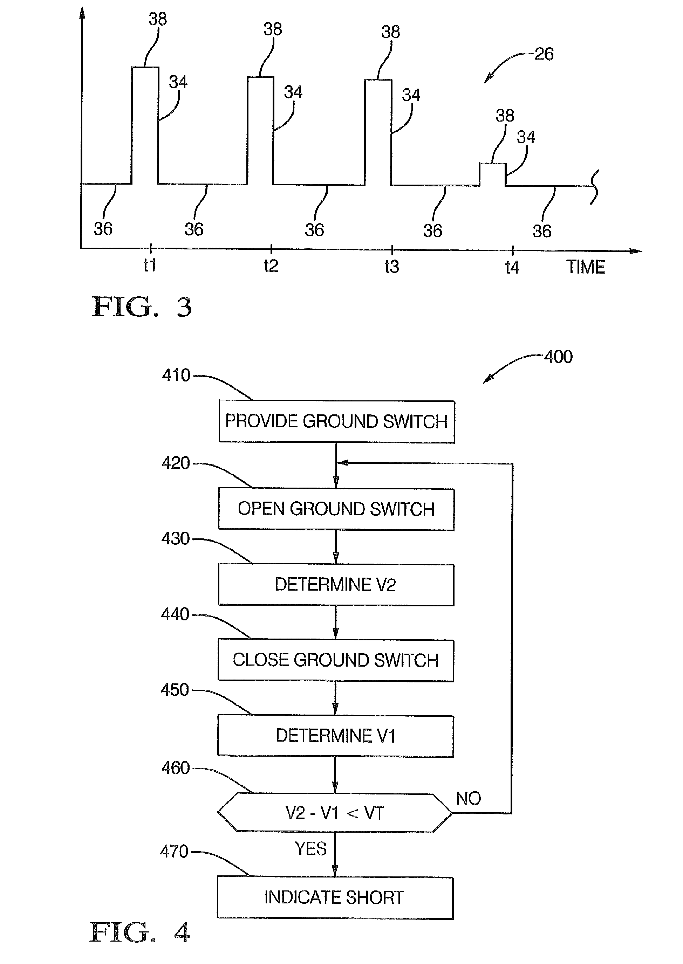

The system 10 includes a ground switch 28 operable to a closed state and an open state. The ground switch 28 is illustrated as being within the controller 14, but it is contemplated that the ground switch 28 could be located elsewhere, such as part of a wiring harness 40 between the external sensor 12 and the controller 14. In general, the ground switch 28 is configured to electrically connect the return line 16 to a ground potential 30 when the ground switch 28 is operated to the closed state, and to electrically float or isolate the return line 16 when the ground switch 28 is operated to the open state. The ground switch 38 may be a solid-state device such as a transistor, for example a metal oxide semi-conductor field effect transistor (MOSFET), or a relay, or other component suitable to couple and de-couple the return line 16 to the ground potential 30. As will become apparent in the description that follows, by operating the ground switch 28 to the open state, there may be a value change 34 (Fig. 3) to the sensor signal 26 defined in this example as a difference between a signal first value 36 and a signal second value 38 that can be measured, and if the value change in the sensor signal 26 is not what was expected, then that may be an indication that the return line 16 is shorted to ground at some location other than via the ground switch 28.

The system 10 may include a processor 32 configured to receive the sensor signal 26. The processor 32 may be a microprocessor or other control circuitry as should be evident to those in the art. The processor 32 may include memory, including non-volatile memory, such as electrically erasable programmable read-only memory (EEPROM) for storing one or more routines, thresholds and captured data. The one or more routines may be executed by the processor 32 to perform steps for operating the ground switch 28, and determining if sensor signal 26 received by the processor 32 indicates a short to ground of the return line 16 as described herein. By way of an example, the processor 32 may detect a short to ground condition of the return line 16 if a value change 34 of the sensor signal 26 is less than a threshold value when the ground switch 28 is operated or switched from the closed state to the open state. As will become apparent in the description that follows, the threshold value would need to be determined analytically and/or empirically for the specific configuration of the external sensor 12. Fig. 3 illustrates a non-limiting example of a graph a sensor signal 26. For the purpose of explanation, it will be assumed that the graph is of the signal output by EMF1 20, i.e. the first cell signal 26b. In this example, the signal first value 36 corresponds to when the ground switch 28 is in the closed state, and the signal second value 38 corresponds to when the ground switch is in the open state. If EMF1 is a typical chemical sensor, the voltage output by EMF1 may be in the range of a few tenths of a volt (V), for example 0V to 0.4V, depending on the composition of gas to which EMF1 is exposed. With the ground switch 28 in the closed state, the signal first value 36 would then be about 0V to 0.4V. With the ground switch 28 in the open state, the signal second value 38 corresponding to this open state would be influenced by the design of the external sensor 12, and if the wire harness 40 had any shorts to ground or other potentials. For this non-limiting example, the controller 14 may include a test pulse generator 42 configured to output a test signal that feeds through the temperature sensor cell 18 while the ground switch 28 in in the open state and thereby causes the signal second value 38 shown just prior to time t1, t2, and t3 on the graph, for example 5.0 volts. However, if the return line 16 is subject to a short to ground, the signal second value 38 may be that shown just prior to time t4, for example 0.7V. For this example, a suitable threshold value may be 3.0V.

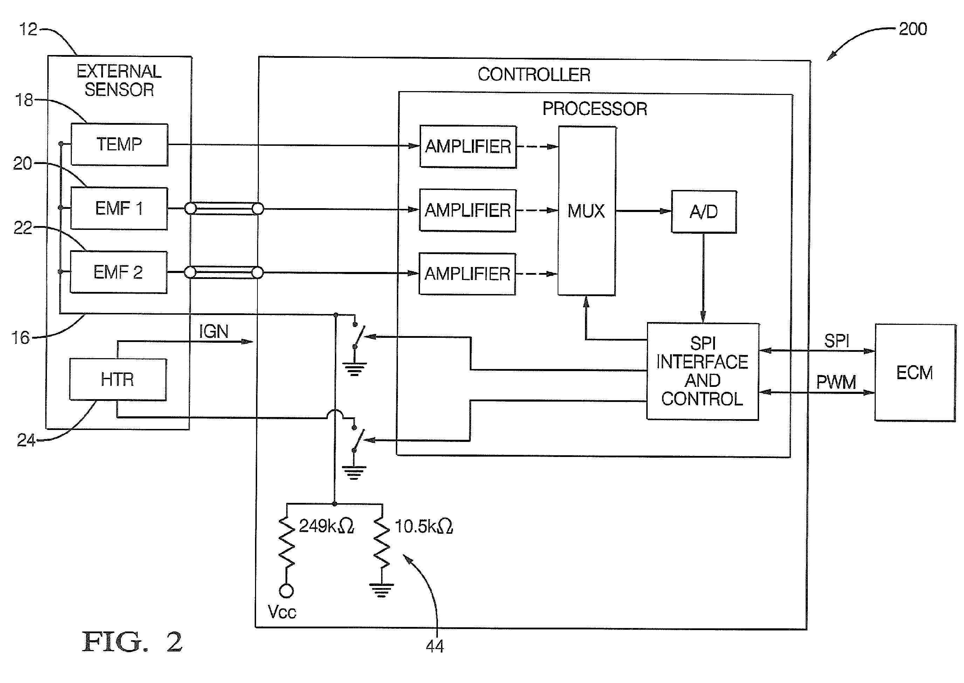

If a short to ground is detected, the controller 14 may send a signal to the vehicle engine control module (ECM) 44 indicating that a fault has been detected, and the ECM 44 may take some remedial action such as illuminating a service engine soon indicator on a vehicle instrument panel. It is recognized that the controller 14 may be incorporated into the ECM 44, but is shown herein as a separate entity only for the purpose of explanation. Fig. 2 illustrates an alternative embodiment of a system to detect a short to ground condition of a return line of the system that includes a weak voltage source, hereafter the system 200. As used herein, a weak voltage source is characterized as a voltage source having source resistance that is sufficiently high to prevent damage the ground switch 28 when the ground switch 28 is in the closed state, but sufficiently low to influence the sensor signal 26 when the ground switch is in the open state. As such, it may not be necessary to provide the test pulse generator 42 shown in Fig. 1.

In this example of the system 200, a suitable value for Vcc is 5.0V and a suitable voltage divider network includes a 249 kilo-Ohm (kΩ) resistor and a 10.5 kΩ resistor, thereby providing a weak voltage source having an open circuit voltage of about 0.2V and a source resistance of about 10 kΩ. The example given for Fig. 1 suggests that a substantial voltage is on the order of a volt or two, while this example suggests that a substantial voltage is on the order of a tenth of a volt. It should be appreciated that the threshold voltage and any voltage provided by the weak voltage source characterized as substantially different from the ground potential is selected in view of the design and sensor technology used in the external sensor 12.

Fig. 4 illustrates a non-limiting example of a method 400 to detect a short to ground condition of a return line 16 electrically coupling an external sensor 12 to a controller 14. Step 410, PROVIDE GROUND SWITCH, may include providing a ground switch 28, for example a MOSFET, that is coupled to the return line16, the ground potential 39, and the processor 32 in a manner known in the art. In general, the ground switch 28 is operable to a closed state and an open state. As describe above, the ground switch 28 is configured to connect the return line 16 to a ground potential 30 when the ground switch 28 is in the closed state, and electrically isolate the return line 16 from the ground potential 30 when the ground switch 28 is in the open state.

Step 420, OPEN GROUND SWITCH, may include the controller 14 outputting a control signal 46 that operates the ground switch to an open state. By way of example and not limitation, the ground switch 28 may be periodically opened for a time interval of one hundred milliseconds (100ms) every three seconds (3s). With this example timing, the external sensor 12 is operated normally for two point nine seconds (2.9s), and then a check for a short to ground is done during the 100ms that the ground switch 28 is in the open state.

Step 430, DETERMINE V2, may include determining a signal second value 38 (V2) of the sensor signal 26 from the external sensor 12 while the ground switch 28 is in the open state.

Step 440, CLOSE GROUND SWITCH, may include the controller 14 outputting a control signal 46 that operates the ground switch 28 to a closed state.

Step 450, DETERMINE V1, may include determining a signal first value 36 (V1) of the sensor signal 26 from the external sensor 12 while the ground switch 28 is in the open state

Step 460, V2 - V1 < VT, may include determining if a difference between the signal first value 36 and a signal second value 38 is less than a threshold value. If the test result is NO, then the method 400 returns to step 420 and the cycle of operating the ground switch 28 to the open state in order to check for shorts to ground is repeated. If the test result is YES, then there is an indication that the return line 16 may have an unexpected connection to ground, i.e. a short to ground, and so the method 400 proceeds to step 470 Step 470, INDICATE SHORT, may include indicating that a short to ground condition of the return line exists if a difference between the signal first value 36 and a signal second value 38 is less than a threshold value. Indicating that a short to ground condition exists may include illuminating a 'SERVICE ENGINE SOON' indicator on the vehicle instrument panel (not shown).

Accordingly, a system 10, a controller 14 for the system 10 and a method 400 to detect a short to ground condition of a return line 16 electrically coupled to an external sensor 12 is provided. In normal operation, the ground switch 28 is closed. The system 10 opens the ground switch 28 in the return line 16 and expects to see a change in response of one or more of the signals from the external sensor 12. If these changes are not detected, it may be surmised that the return line 16 is shorted to ground outside of the controller 14. If appropriate changes are detected, the return line 16 is assumed to be properly insulated.

While this invention has been described in terms of the preferred embodiments thereof, it is not intended to be so limited, but rather only to the extent set forth in the claims that follow.

## Claims

1. A controller (14) configured to detect a short to ground condition of a return line (16) electrically coupled to an external sensor (12), said external sensor (12) configured to output a sensor signal (26) relative to the return line (16), said controller (14) comprising:
a ground switch (28) operable to a closed state and an open state, wherein said ground switch (28) is configured to electrically connect the return line (16) to a ground potential (30) when the ground switch (28) is in the closed state;
a processor (32) configured to receive the sensor signal (26), and operate the ground switch (28) to the closed state and the open state, wherein said processor (32) detects a short to ground condition of the return line (16) if a value change (34) of a sensor signal (26) is less than a threshold value when the ground switch (28) is switched from the closed state to the open state.

2. The controller (14) in accordance with claim 1, wherein said controller (14) further comprises a weak voltage source electrically coupled to the return line (16), said weak voltage source configured to output an open circuit voltage potential substantially different from the ground potential (30).

3. A system (10) configured to detect a short to ground condition of a return line (16) of the system (10), said system (10) comprising:
an external sensor (12) electrically coupled to the return line (16), said external sensor (12) configured to output a sensor signal (26) relative to the return line (16);
a ground switch (28) operable to a closed state and an open state, wherein said ground switch (28) is configured to electrically connect the return line (16) to a ground potential (30) when the ground switch (28) is in the closed state; and
a processor (32) configured to receive the sensor signal (26), and operate the ground switch (28) to the closed state and the open state, wherein said processor (32) detects a short to ground condition of the return line (16) if a value change (34) of a sensor signal (26) is less than a threshold value when the ground switch (28) is switched from the closed state to the open state.

4. The system (10) in accordance with claim 3, wherein said system (10) further comprises a weak voltage source electrically coupled to the return line (16), said weak voltage source configured to output an open circuit voltage potential substantially different from the ground potential (30).

5. A method (400) to detect a short to ground condition of a return line (16) electrically coupling an external sensor (12) to a controller (14), said method (400) comprising:
providing (410) a ground switch (28) coupled to the return line (16), said ground switch (28) operable to a closed state and an open state, and configured to connect the return line (16) to a ground potential (30) when the ground switch (28) is in the closed state;
determining (450) a signal first value (36) of a sensor signal (26) from the external sensor (12) while the ground switch (28) is in the closed state (440);
determining (430) a signal second value (38) of the sensor signal (26) from the external sensor (12) while the ground switch (28) is in the open state (420); and
indicating (470) that a short to ground condition of the return line (16) exists if (460) a value change (34) indicative of a difference between the signal first value (36) and the signal second value (38) is less than a threshold value.
